(19) Europäisches Patentamt

European Patent Office

Office européen des brevets

(11) **EP 0 961 383 A1**

(12) **EUROPÄISCHE PATENTANMELDUNG**

(43) Veröffentlichungstag:
**01.12.1999 Patentblatt 1999/48**

(51) Int. Cl.$^6$: **H02J 9/00**

(21) Anmeldenummer: 98109869.2

(22) Anmeldetag: **29.05.1998**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(71) Anmelder:
**SIEMENS AKTIENGESELLSCHAFT**
**80333 München (DE)**

(72) Erfinder:
• **Baumgartner, Walter**
  **93197 Zeitlarn (DE)**
• **Hermann, Stefan**
  **93096 Köfering (DE)**
• **Bauer, Klaus**
  **93053 Regensburg (DE)**

(54) **Verfahren zum Überprüfen der Kapazität in einem Insassenschutzsystem vorgesehenen Speicherkondensators sowie Prüfvorrichtung**

(57)    Die Kapazität eines in einem Insassenschutzsystem eines Kfz enthaltenen Zündkondensators zum Zünden einer Zündpille wird an der aufsteigenden Flanke der Kondensatorspannung in einer Auflade- phase durchgeführt. Hierzu wird die während einer Testzeitspanne durch den Speicherkondensator aufge- nommene Ladungsmenge durch Messung des Lade- stromes oder eines entspr. Wertes und Integrieren über der Testzeitspanne ermittelt. Die Kapazität wird durch den Quotienten des resultierenden Integrals und der in der Testzeitspanne erfolgten Spannungsänderung der Kondensatorspannung erhalten. Die Funktionsbereit- schaft des Zündkondensators wird zu keiner Zeit beein- trächtigt.

FIG 1

EP 0 961 383 A1

**Beschreibung**

Die Erfindung betrifft ein Verfahren zum Überprüfen der Kapazität eines in einem Insassenschutzsystem vorgesehenen Speicherkondensators, gemäß dem Oberbegriff des Patentanspruchs 1. Weiterhin betrifft die Erfindung eine Prüfvorrichtung gemäß dem Oberbegriff des Patentanspruchs 6. Die Erfindung bezieht sich insbesondere auf Insassenschutzsysteme in Kraftfahrzeugen wie Rückhaltesysteme, zum Beispiel Gurtstrammersysteme oder Airbagsysteme.

Ein Insassenschutzsystem eines Kraftfahrzeugs muß bei einem Unfall zuverlässig auslösen. Dazu ist ein oder sind mehrere Speicherkondensatoren vorgesehen, die beispielsweise für die Zündung von Zündpillen ausreichende Leistung sicherstellen. Auch im Notfall bei Ausfall einer vom Bordnetz betriebenen Energiequelle ist die Stromversorgung sichergestellt. Solche Speicherkondensatoren können auch als Hilfsspannungsquellen für elektronische Schaltungen oder dergleichen benutzt werden. Zur Gewährleistung der Funktionsfähigkeit des Insassenschutzsystems muß sichergestellt sein, daß die Kapazität des insbesondere als Zündkondensator eingesetzten Speicherkondensator ausreichend ist. Daher ist eine Überprüfung der Kapazität solcher Speicherkondensatoren nach deren Einbau oder auch nach einem oder jedem Einschalten des Insassenschutzsystems erforderlich.

Aus der DE 195 08 850 A1 ist ein Verfahren zum Überprüfen der Kapazität eines Speicherkondensators nach dem Oberbegriff des Patentanspruchs 1 und eine ein solches Verfahren ermöglichende Prüfvorrichtung eines Insassenschutzsystems nach dem Oberbegriff des Patentanspruchs 6 bekannt. Danach wird die Kapazität des Speicherkondensators dadurch überprüft, daß der von einer Spannungsquelle nach dem Einschalten aufgeladene Speicherkondensator von der Spannungsquelle getrennt wird und durch eine Entladeschaltung mit einem definierten Entladestrom über eine bestimmte Testzeitspanne oder Meßdauer entladen wird. Aus dem Entladestrom und der Testzeit wird die Änderung der Kondensatorladung durch Multiplikation bestimmt und durch eine erfaßte Änderung der Kondensatorspannung dividiert, um so die Kapazität zu bestimmen. Bei fehlerhafter Kapazitätsbestimmung besteht die Gefahr, daß der Speicherkondensator soweit entladen wird, daß er nicht mehr funktionstüchtig ist. Die bekannte Prüfvorrichtung enthält daher eine Schutzschaltung, die die Kapazitätsbestimmung abbricht, wenn die Kondensatorspannung unter einen Mindestwert fällt. Da der Speicherkondensator auch noch bei diesem Mindestspannungswert genügend Energie liefern können muß und mit der verfügbaren Spannungsquelle auf einen höheren Spannungswert aufladbar sein muß, von dem aus er zur Kapazitätsmessung entladen wird, muß er größer dimensioniert werden als eigentlich notwendig, was den Platzbedarf der bekannten Prüfvorrichtung vergrößert. Die zusätzlich benötigten Schaltungen, also die Schutzschaltung und die Entladeschaltung, bedingen weiteren Aufwand und Platzbedarf der Prüfvorrichtung. Außerdem benötigt der Prüfvorgang wegen des Aufladens, Entladens und erneuten Aufladens des Speicherkondensators auf Betriebsspannung eine relativ lange Zeit. Insgesamt ist das bekannte Verfahren kompliziert und die dazu verwendbare Prüfvorrichtung sehr aufwendig und daher teuer. Der gravierendste Nachteil der bekannten Kapazitätsüberprüfung ist jedoch der durch die Messung bedingte Verbrauch wertvoller gespeicherter Energie.

Der Erfindung liegt die Aufgabe zugrunde, ein Verfahren sowie eine Vorrichtung zum Überprüfen der Kapazität eines in einem Insassensystem vorgesehenen Speicherkondensators zu schaffen, das bzw. die eine Überprüfung ohne Verbrauch der nach dem Aufladen in dem Speicherkondensator gespeicherten Energie zuläßt und mit geringem Aufwand verbunden ist.

Der das Verfahren betreffende Teil der Erfindungsaufgabe wird mit den im Patentanspruch 1 angegebenen Merkmalen gelöst.

Die Unteransprüche 2 bis 5 kennzeichnen vorteilhafte Weiterbildungen des Verfahrens.

Der auf die Vorrichtung gerichtete Teil der Erfindungsaufgabe wird mit den Merkmalen des Anspruchs 6 gelöst.

Vorteilhafte Ausgestaltungen der Vorrichtung sind in den Unteransprüchen 7 bis 10 angegeben.

Erfindungsgemäß wird eine Kapazitätsbestimmung an der aufsteigenden Flanke der Kondensatorspannungskurve in der Aufladephase durchgeführt. Dadurch ist der durchgemessene Speicherkondensator nach der Kapazitätsbestimmung voll funktionsbereit, ohne daß er erneut aufgeladen werden müßte. Die zum Bestimmen der Kapazität erforderliche Ladungsänderung der Kondensatorladung wird dabei nicht über einen definierten Entladestrom, sondern über den (Auf-)Ladestrom bestimmt. Dieser ohnehin während einer Aufladephase von einer Ladungsträgerquelle zu dem Kondensator fließende Ladestrom muß nicht extra erzeugt werden, sondern wird lediglich während der Meßdauer bestimmt, um die Änderung der Kondensatorladung zu kennen. Wenn zusätzlich die während der Meßdauer erfolgte Änderung der Kondensatorspannung bestimmt wird, kann aus dem Quotienten der Änderungen von Kondensatorladung und -spannung die Kapazität des Kondensators errechnet werden.

Ein ungewollt nicht rechtzeitiges Beenden der Kapazitätsmessung oder -bestimmung hat anders als bei bisher bekannten Verfahren keinen Einfluß auf die Funktionsfähigkeit des Speicherkondensators, da dieser - wie ohne Messung auch - vollständig aufgeladen wird. Die Erfindung ermöglicht eine Kapazitätsbestimmung ohne separate Entladeschaltung und Schutzschaltung. Der Speicherkondensator muß aus Gründen der Kapazitätsmessung nicht überdimensioniert werden. Insgesamt ist damit eine Prüfvorrichtung mit wenig zusätzlichem Platzbedarf und Hardwareaufwand realisierbar.

In bevorzugter Ausführung wird der Ladestrom durch einen definierten Ladewiderstand zwischen der Ladungsträgerquelle und dem Speicherkondensator begrenzt, so daß die Aufladephase gestreckt wird und zur Kapazitätsbestimmung ausreichend Zeit und günstigere Strom- und/ oder Spannungsverläufe zur Verfügung stehen. Die Bestimmung des Ladestromes erfolgt dann bevorzugt über einen gemessenen Spannungsabfall an dem Ladewiderstand. Die Ladungsänderung der Kondensatorladung wird vorzugsweise durch zumindest näherungsweise Integration des Ladestroms über die Meßdauer erhalten, d.h. im Falle eines Spannungsabgriff an dem Ladewiderstand durch Integration des Spannungsabfalls über der Testzeitspanne und Division durch den Widerstandswert des Ladewiderstandes.

Durch eine zum Feststellen der Spannungsänderung der Kondensatorspannung erfolgende Bestimmung der Kondensatorspannung in der Aufladephase ist es in bevorzugter Ausgestaltung der Erfindung außerdem noch möglich, den Aufladevorgang zu überwachen und zum Beispiel frühzeitig festzustellen, ob der Aufladepfad unterbrochen ist oder ob oder wann der Speicherkondensator eine ausreichende Energie gespeichert hat.

Die Erfindung wird nachstehend anhand von Ausführungsbeispielen unter Bezugnahme auf die Zeichnungen näher beschrieben.

Fig. 1 zeigt ein schematisches Blockschaltbild einer Prüfvorrichtung für ein Insassenschutzsystem gemäß einer ersten Ausführungsform,

Fig. 2 zeigt eine Darstellung von Spannungsverläufen bei einem Einschalten der Prüfvorrichtung nach Fig. 1, und

Fig. 3 zeigt ein schematisches Blockschaltbild eines in einer Prüfvorrichtung nach einer weiteren Ausführungsform verwendeten separaten Ladekreises für einen Speicherkondensator.

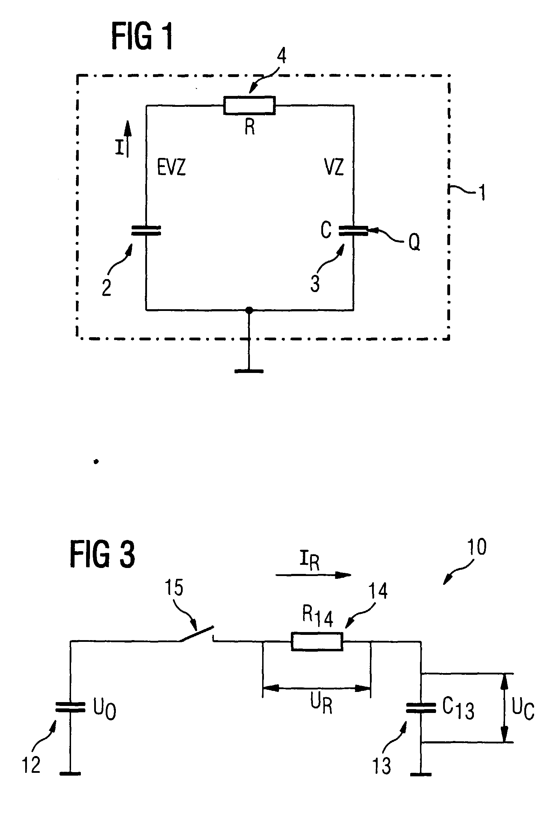

Die in Fig. 1 gezeigte Prüfvorrichtung 1 ist Bestandteil eines Insassenschutzsystems eines Kraftfahrzeuges und empfängt Signale von einem oder mehreren (nicht dargestellten) im Kraftfahrzeug angeordneten Unfallsensoren. Die Prüfvorrichtung 1 ist mit einem Bordnetz zur Energieversorgung verbunden und mit einem nicht dargestellten Mikroprozessor versehen, der die Signale der Unfallsensoren auswertet und bei Erfassung eines Unfalls eine mit der Prüfvorrichtung 1 verbundene, nicht dargestellte Zündpille, beispielsweise die Zündpille eines Airbags, aktiviert. Auch mehrere Zündpillen können zur gefahrensituationsbedingten Zündung mit der Steuervorrichtung 1 verbunden sein.

Die Prüfvorrichtung 1 ist ein Steuergerät, das eine Spannungsquelle 2 enthält. Die Spannungsquelle 2 bezieht ihre Eingangsenergie aus dem Bordnetz des Kraftfahrzeugs und lädt einen parallel zu ihr geschalteten Zündkondensator 3 auf eine vorgegebene Spannung auf. Die Spannungsquelle 2 wirkt damit als Ladungsträgerquelle für den Zündkondensator 3. Die Spannungsquelle 2 kann ein Spannungsgenerator sein, der eine höhere Spannung als die Bordnetzspannung als Ladespannung oder Quellenspannung für den Zündkondensator 3 ausgibt. Anstelle der Spannungsquelle 2 kann auch eine Stromquelle als Ladungsträgerquelle zum Aufladen des Zündkondensators 3 auf den vorgegebenen Spannungswert dienen. Der Zündkondensator 3 dient als Speicherkondensator, der auch eine ausreichende Zündleistung sicherstellt und eine Notstromversorgung des Insassenschutzsystems zum Zünden der Zündpille bei Ausfall des Bordnetzes gewährleistet. Anstelle des Zündkondensators 3 kann auch ein durch eine Kombination mehrerer parallel oder in Reihe geschalteter Zündkondensatoren gebildeter Speicherkondensator vorhanden sein.

Ein Ladewiderstand 4 ist in Reihe zwischen die Spannungsquelle 2 und den Zündkondensator 3 geschaltet. Der Ladewiderstand 4 besitzt einen definierten Widerstandswert R und ist Bestandteil eines Ladeschaltkreises zum Aufladen des Zündkondensators 3 durch die Spannungsquelle, wo er den von der Spannungsquelle 2 zu dem Zündkondensator fließenden Ladestrom begrenzt.

Das Überprüfen der Kapazität (des Kapazitätswerts) C des Zündkondensators 3 erfolgt durch Strom- bzw. Spannungsmessing und mittels im Mikroprozessor der Prüfvorrichtung 1 abgelegter Software. Insgesamt weist die Prüfvorrichtung eine Testzeitsteuereinrichtung, eine Spannungsänderungserfassungseinrichtung und eine Ladungsänderungserfassungseinrichtung auf.

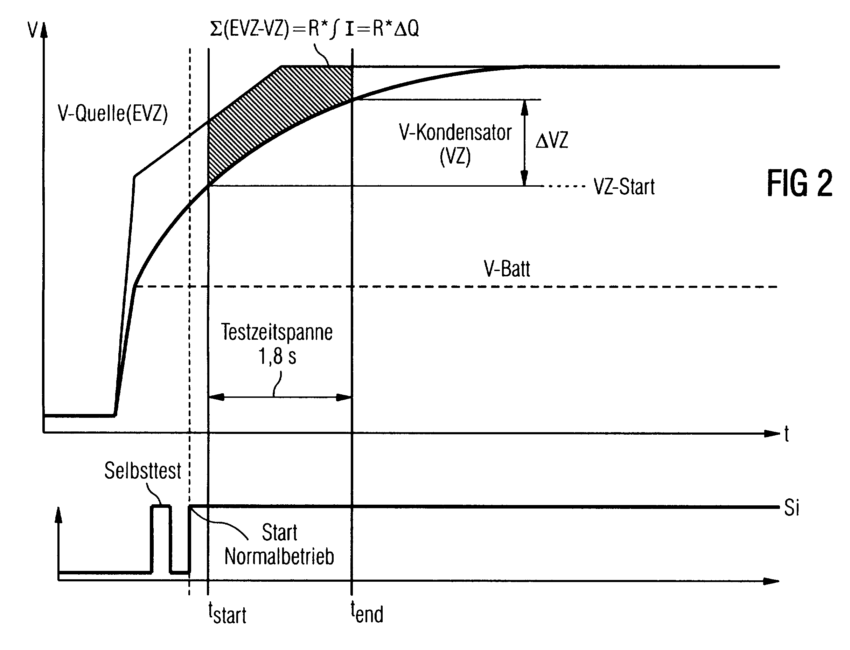

Die Testzeitsteuerungseinrichtung empfängt nach dem Einschalten des Bordnetzes ein Steuersignal, das den Beginn eines Normalbetriebes anzeigt, leitet daraufhin einen Test bzw. eine Messung zum Überprüfen der Kapazität C ein und beendet diesen Test nach einer bestimmten Testzeitspanne. Wie aus Fig. 2 ersichtlich, ist die Testzeitsteuerungseinrichtung so zeitgesteuert, daß sowohl der Anfangszeitpunkt $t_{start}$ als auch der Endzeitpunkt $t_{end}$ der Messung innerhalb einer Aufladephase des Zündkondensators 3 liegen. Der Anfangszeitpunkt $t_{start}$ liegt, wie aus den unteren Diagrammen der Fig. 2 ersichtlich, nach dem Einschalten des Bordnetzes bzw. Ladebeginn des Kondensators, das das System, wie an sich bekannt, zunächst einen Selbsttest durchführt, dessen i.O. Voraussetzung für den weiteren Ablauf ist.

Die Spannungsänderungserfassungseinrichtung ermittelt aufgrund momentaner Werte der Kondensatorspannung VZ, die durch Messung des Potentials der Leitung zwischen dem Ladewiderstand 4 und dem Zündkondensator 3 erfaßt werden, die Spannungsänderung ΔVZ der Kondensatorspannung VZ zwischen dem Anfangszeitpunkt $t_{start}$ und

dem Endzeitpunkt $t_{end}$ der Testzeitdauer, die beispielsweise 1,8 s beträgt.

Die Ladungsänderungserfassungseinrichtung bestimmt die Ladungsänderung $\Delta Q$ der Kondensatorladung Q zwischen dem Anfangszeitpunkt $t_{start}$ und Endzeitpunkt $t_{end}$ der Testzeitspanne. Hierzu weist die Ladungsänderungserfassungseinrichtung eine Ladestromerfassungseinrichtung, die den Ladestrom I oder einen diesem entsprechenden Wert während der Testzeitspanne bestimmt, und eine Integriereinrichtung zum zumindest näherungsweisen Bilden eines Integrals des Ladestroms I oder des dem Ladestrom entsprechenden Werts über der Testzeitspanne auf. Die Ladestromerfassungseinrichtung ermittelt aufgrund eines Potentials, das auf der Leitung zwischen der Spannungsquelle 2 und dem Ladewiderstand 4 durch die Spannungserfassungseinrichtung gemessen wird und der zum Aufladen des Zündkondensators 4 zur Verfügung stehenden Quellenspannung EVZ der Spannungsquelle 2 entspricht, und aufgrund des auf der Leitung zwischen dem Ladewiderstand 4 und dem Zündkondensator 3 von der Spannungserfassungseinrichtung gemessenen, der Kondensatorspannung VZ entsprechenden Potentials den Spannungsabfall am Ladewiderstand 4, d.h. die an dem Ladewiderstand 4 anliegende Spannung (EVZ-VZ). Die Integriereinrichtung integriert diese über den Ladewiderstand 4 anliegende, nach dem Ohm'schen Gesetz dem Ladestrom I entsprechende Spannung (EVZ-VZ) über die Testzeitspanne. Aus dem resultierenden Integral und dem Widerstandswert R des Ladewiderstandes 4 ermittelt die Ladungsänderungserfassungseinrichtung die Änderung $\Delta Q$ der Kondensatorladung Q nach der Gleichung:

$$\Delta Q = \int I \times dt = R^{-1} \times \int (EVZ - VZ) \times dt \qquad (1)$$

oder genauer nach der Gleichung:

$$\Delta Q = \int_{t_{start}}^{t_{end}} I \times dt = R^{-1} \times \int_{t_{start}}^{t_{end}} (EVZ - VZ) \times dt \qquad (1')$$

Die Prüfvorrichtung ermittelt aus der Änderung $\Delta Q$ der Kondensatorladung und der Änderung $\Delta VZ$ der Kon-densatorspannung die Kapazität des Zündkondensators 3 nach der Gleichung:

$$C = \Delta Q / \Delta VZ \qquad (2)$$

In Fig. 2 sind im oberen Diagramm die Verläufe der Kondensatorspannung VZ (mit "V-Kondensator" bezeichnet) am Zündkondensator 3 und der Quellenspannung EVZ (mit "V-Quelle" bezeichnet) bei einem Aufladevorgang nach einem Einschalten des Insassenschutzsystems dargestellt, wobei auf der Abzisse die Zeit t und auf der Ordinate die jeweilige Spannung V angegeben ist.

In dem unteren Diagramm von Fig. 2 ist, wie bereits erwähnt, der Verlauf eines den Betriebszustand des Insassenschutzsystems anzeigenden Steuersignals Si, eines Logiksignals, angegeben. Nach dem Einschalten wird durch das Steuersignal Si zunächst ein Selbsttestimpuls zum Durchführen eines Selbsttests ("Watchdog"-Test) verschiedener Komponenten und der Software abgegeben. Das zunächst auf "High" gesetzte Steuersignal Si wird zum Rücksetzen nach den Selbsttests durch die Software auf "Low" gesetzt und geht dann wieder auf "High", was Betriebstüchtigkeit des Systems bedeutet und das Starten eines Normalbetriebes anzeigt. Nach während der Zündkondensator 3 aufgeladen wird, wird der Test bzw. die Messung zum Überprüfen der Kapazität C des Zündkondensators 3 durchgeführt. Dazu wird kurz nach dem Beginn des Normalbetriebes die Testzeitspanne bei $t_{start}$ gestartet und der Test wird für die bestimmte Testzeitspanne, z.B. für 1,8 s, bis zum Endzeitpunkt $t_{end}$ durchgeführt. Dabei wird die Kondensatorspannung VZ-Start zum Anfangszeitpunkt $t_{start}$ und die Kondensatorspannung zum Endzeitpunkt $t_{end}$ erfaßt, um die Änderung $\Delta VZ$ zu erhalten. Durch Bilden von $\Sigma(EVZ-VZ)$, der Aufsummation des durch Spannungsabgriff am Ladewiderstand 4 erfaßten Spannungsabfalls, der der Differenz der Kondensatorspannung VZ von der Quellenspannung EVZ entspricht, über konstante kleine Teilzeitbereiche der Zeitspanne, wird ein Wert erhalten, der dem Integral des Ladestromes I über der Testzeitspanne multipliziert mit dem Widerstandswert R näherungsweise entspricht und zur Bestimmung der während der Testzeit durch den Zündkondensator 3 aufgenommenen Ladung $\Delta Q$ herangezo-

gen werden kann. V-Batt zeigt das Spannungsniveau des Bordnetzes bei dem hier dargestellten Ausführungsbeispiel an.

Anstatt des in Fig. 2 gezeigten Verlaufes der Quellenspannung (V-Quelle) EVZ sind je nach Art der eingesetzten Spannungsquelle 2 oder Ladungsträgerquelle auch andere Verläufe möglich. Die in Fig. 2 vorhandenen Knickstellen können durch bestimmte Eigenschaften einer bei der Spannungsquelle 2 vorgesehenen integrierten Schaltung sein, müssen aber nicht vorhanden sein. Es ist im Prinzip auch der Einsatz einer Konstantspannungsquelle oder ein sonstiger linearer Spannungsverlauf für V-Quelle denkbar. Durch die zumindest näherungsweise wie bei Fig. 2 beschriebene Integralbildung fallen solche Quellenspannungsverlaufunterschiede nicht ins Gewicht. Je nach eingesetzter Meßtechnik müssen auch nicht beide Spannungen EVZ und VZ gemessen werden, sondern es kann die eine Spannung aus einer Messung des Stromes durch den Ladewiderstand und aus der anderen, gemessenen Spannung erhalten werden.

Sind anstatt des Zündkondensators 3 mehrere parallel und/oder in Reihe geschalteten Kondensatoren zu einem Speicherkondensator kombiniert, so kann vorgesehen sein, daß die Prüfvorrichtung anlog zu der beschriebenen Weise zum Prüfen der Gesamtkapazität oder zum Prüfen der Kapazität jedes einzelnen Kondensators geeignet ist. Alternativ kann für jeden in einem Insassenschutzsystem vorhandenen Speicherkondensator ein separater Ladekreis und eine separate Prüfeinrichtung vorhanden sein.

In Fig. 3 ist ein Beispiel für einen eine solche Schaltung ermöglichenden Ladekreis 10 gezeigt. Als Ladungsträgerquelle dient dabei eine Konstantspannungsquelle 12 mit einer konstanten Quellenspannung $U_0$. Der Aufladepfad, der über einen Ladewiderstand 14 mit dem Widerstandswert $R_{14}$ zu einem Speicherkondensator 13 (der ebenfalls ein Zündkondensator sein kann) führt, ist durch einen Schalter 15, zum Beispiel einem Schalttransistor, unterbrechbar. Der Schalter 15 ist in dem dargestellten Beispiel zwischen der Konstantspannungsquelle 12 und dem Ladewiderstand 14 angeordnet. Während eines durch Schließen des Schalters 15 eingeleiteten Aufladevorgangs wird die über dem Speicherkondensator 13 anliegende Kondensatorspannung $U_c$ und die über dem Ladewiderstand 14 anliegende Spannung $U_R$ gemessen, um daraus den Ladestrom $I_r$ abzuleiten und die Kapazität $C_{13}$ des Speicherkondensators 13 zu bestimmen. Dabei wird die folgende Gleichung für einen innerhalb einer Meßdauer oder Testzeitspanne t erfolgte Spannungsänderung $\Delta U_c$ zugrunde gelegt:

$$\Delta U_c (t) = \frac{1}{c_{13}} \int_0^t I_R (t)\, dt \qquad (3)$$

Aus (3) folgt für die Kapazität:

$$C_{13} = \frac{\int_0^t I_R (t)\, dt}{\Delta U_c (t)} \qquad (4)$$

In der Aufladephase gilt in erster Näherung:

$$I_R (t) \approx \frac{U_0}{R_{14}} = I_0 \qquad (5)$$

wobei $I_0$ einen konstanten Strom symbolisieren soll.

Aus (5) folgt für die Spannungsänderung $\Delta U_c$ der Kondensatorspannung $U_c$:

$$\Delta U_c \ (t) \ \approx \ \frac{I_0}{C_{13}} \ \int_0^t dt \ = \ \frac{I_0}{C_{13}} \ x \ t \ = \ \frac{U_0}{R_{14} \ x \ C_{13}} \ x \ t \qquad (6)$$

woraus sich dann näherungsweise die Kapazität durch

$$C_{13} \ \approx \ \frac{U_0 \ x \ t}{R_{14} \ x \ \Delta U_c \ (t)} \qquad (7)$$

bestimmen läßt.

Das erfindungsgemäße Verfahren zur Kapazitätsüberprüfung kann in vielfältiger Weise abgeändert werden. Beispielsweise kann gemäß Fig. 2 nicht mit vorbestimmter Testzeitspanne gearbeitet werden, sondern innerhalb eines vorbestimmten Spannungsintervalls ΔVZ des Kondensators, indem eine Anfangsspannung VZ-Start einen Meßbeginn triggert und das Erreichen einer vorbestimmten Endspannung das Ende einer Überprüfung bzw. Messung auslöst.

**Patentansprüche**

1. Verfahren zum Überprüfen der Kapazität eines in einem Insassenschutzsystem vorgesehenen Speicherkondensators (3; 13), insbesondere eine Zündkondensators (3) zum Zünden einer Zündpille des Insassenschutzsystems, durch Bestimmen des Quotienten aus einer Ladungsänderung des Speicherkondensators und einer zugehörigen Spannungsänderung des Speicherkondensators, dadurch gekennzeichnet, daß

   - die Kapazität innerhalb einer Aufladephase des Speicherkondensators (3; 13) bestimmt wird.

2. Verfahren nach Anspruch 1, dadurch gekennzeichnet, daß die Ladungsänderung durch zumindest näherungsweises Integrieren des Ladestroms während einer innerhalb der Aufladephase liegenden Testzeitspanne bestimmt wird.

3. Verfahren nach Anspruch 1 oder 2, dadurch gekennzeichnet, daß der Ladestrom aus dem Spannungsabfall an einem zwischen eine Ladungsträgerquelle (2; 12) und den Speicherkondensator (3; 13) geschalteten Ladewiderstand (4; 14) und dem Widerstandswert des Ladewiderstands ermittelt wird.

4. Verfahren nach Anspruch 3, dadurch gekennzeichnet, daß die Spannung des Speicherkondensators (3; 13) an dessen mit dem Ladewiderstand (4; 14) verbundenen Anschluß gemessen wird und die Kondensatorspannung zum Erfassen des Spannungsabfalls an dem Ladewiderstand, zur Bestimmung der Spannungsänderung der Kondensatorspannung, zur Bestimmung der Funktionsfähigkeit des Speicherkondensators und/oder zur Überprüfung des Erfolgs des Aufladevorgangs verwendet wird.

5. Verfahren nach einem der Ansprüche 3 oder 4, dadurch gekennzeichnet, daß die Kapazität (C) des Speicherkondensators (3) erhalten wird über die Formel

$$C = \Delta Q / \Delta VZ$$

   mit

$$\Delta Q = \int I \times dt = R^{-1} \times \int (EVZ - VZ) \times dt \qquad (1)$$

wobei C die zu bestimmende Kapazität, $\Delta Q$ die Ladungsänderung zwischen Beginn ($t_{start}$) und Ende ($t_{end}$) der Testzeitspanne, $\Delta VZ$ die durch Bilden der Differenz der Kondensatorspannungen zwischen Beginn ($t_{start}$) und Ende ($t_{end}$) der Testzeitspanne gebildete Spannungsänderung der Kondensatorspannung (VZ), I der Ladestrom, R der Widerstandswert des Ladewiderstandes (4) und (EVZ - VZ) der Spannungsabfall über dem Ladewiderstand ist.

6. Prüfvorrichtung für einen in einem Insassenschutzsystem enthaltenden Speicherkondensator (3; 13), insbesondere Zündkondensator (3) zum Zünden einer Zündpille, mit

- einer Ladungsträgerquelle (2; 12) zum Aufladen des Speicherkondensators und
- einer Meßeinrichtung zum Bestimmen der Kapazität des Speicherkondensators, die eine Spannungsänderungserfassungseinrichtung zum Bestimmen einer Spannungsänderung der Kondensatorspannung und eine Ladungsänderungserfassungseinrichtung zum Bestimmen einer Ladungsänderung der Kondensatorladung während der Spannungsänderung aufweist,
dadurch gekennzeichnet, daß
die Meßeinrichtung eine Steuereinrichtung enthält, die während einer Aufladung des Speicherkondensators (3; 13) mittels der Ladungsträgerquelle (2; 12) eine Messung einer Spannungsänderung und der zugehörigen Ladungsänderung des Speicherkondensators auslöst.

7. Prüfvorrichtung nach Anspruch 6, dadurch gekennzeichnet, daß die Steuereinrichtung die Messung während einer vorbestimmten Testzeitspanne auslöst.

8. Prüfvorrichtung nach Anspruch 6 oder 7, dadurch gekennzeichnet, daß die Ladungsänderungserfassungseinrichtung eine Integriereinrichtung zum zumindest näherungsweise Integrieren eines dem Ladestrom des Speicherkondensators entsprechenden Wertes für die Meßzeitdauer aufweist.

9. Prüfvorrichtung nach einem der Ansprüche 5 bis 8, dadurch gekennzeichnet, daß zwischen die Ladungsträgerquelle (2; 12) und den Speicherkondensator (3; 13) ein Ladewiderstand (4; 14) geschaltet ist und die Spannungsänderungserfassungeinrichtung die Kondensatorspannung an einem mit dem Ladewiderstand verbundenen Anschluß des Speicherkondensators erfaßt.

10. Prüfvorrichtung nach Anspruch 9, dadurch gekennzeichnet, daß die Spannungsänderungserfassungeinrichtung eine Quellenspannung an einem mit dem Ladewiderstand (4) verbundenen Ausgang der Ladungsträgerquelle (2) bestimmt, und die Ladungsänderungserfassungseinrichtung den Ladestrom aus dem Widerstandswert des Ladewiderstandes (4) und aus der Differenz zwischen der Quellenspannung und der Kondensatorspannung bestimmt.

# FIG 1

# FIG 3

FIG 2

$\Sigma(EVZ\text{-}VZ) = R^* \int I = R^* \Delta Q$

V-Quelle(EVZ)

V-Kondensator (VZ)

$\Delta VZ$

VZ-Start

V-Batt

Testzeitspanne 1,8 s

Selbsttest

Start Normalbetrieb

Si

$t_{start}$

$t_{end}$

t

EP 0 961 383 A1

9

**Europäisches Patentamt**

# EUROPÄISCHER RECHERCHENBERICHT

Nummer der Anmeldung

EP 98 10 9869

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| D,A | DE 195 08 850 A (TELEFUNKEN MICROELECTRON) 12. September 1996 * Zusammenfassung * | 1-10 | H02J9/00 |
| A | DE 196 34 320 A (BOSCH GMBH ROBERT) 26. Februar 1998 * Zusammenfassung * | 1-10 | |
| A | EP 0 338 413 A (TRW INC) 25. Oktober 1989 * Zusammenfassung * | 1-10 | |
| | | | **RECHERCHIERTE SACHGEBIETE (Int.Cl.6)** |
| | | | H02J G01R |

Der vorliegende Recherchenbericht wurde für alle Patentansprüche erstellt

| Recherchenort | Abschlußdatum der Recherche | Prüfer |
|---|---|---|
| DEN HAAG | 28. Oktober 1998 | Moyle, J |